# EUROPEAN PATENT APPLICATION

(11) **EP 4 769 021 A1**
(43) Date of publication of application: **01.07.2026**
(21) Application number: 24223268.4
(22) Date of filing: 24.12.2024
(51) Int. Cl.: G03F 7/00

(54) **A METROLOGY SYSTEM**

(71) Applicant: ASML Netherlands B.V., 5500 AH Veldhoven (NL)
(72) Inventor: PELLEMANS, Henricus Petrus Maria, 5500 AH Veldhoven (NL); BEUKMAN, Arjan Johannes Anton, 5500 AH Veldhoven (NL)
(74) Representative: ASML Netherlands B.V.

(57) **Abstract**

A metrology system comprises: a substrate support; a sensor support; a plurality of position sensors; and a processor. The plurality of position sensors are supported by the sensor support and each one is operable to: project a radiation beam onto a substrate; receive a portion of the radiation beam scattered from a target on the substrate; and generate a measurement signal that is indicative of a position of the target relative to that position sensor. The processor is configured to: receive the measurement signal from each of the plurality of position sensors; and to combine the measurement signals from at least two different of the plurality of position sensors to at least partially correct at least one of the measurement signals for a position error so as to determine a corrected position of the target relative to the substrate support.

## Description

### FIELD

The present invention relates to a metrology system for determining the position of targets on a substrate. The metrology system may form part of an exposure apparatus, for example a lithographic apparatus or lithographic tool. Alternatively, the metrology system may form part of a tool which is separate from such an exposure apparatus. The present invention also relates to an exposure apparatus comprising the new metrology system. The present invention also relates to a method for determining a correction for a position measurement. The present invention also relates to a method for determining a position of a plurality of targets on a substrate.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern defined by a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Within a lithographic apparatus, the substrate (for example a resist-coated wafer) is supported by a stage and is typically clamped to the stage (for example using an electrostatic clamp). Once a substrate has been clamped to the stage, it is desirable to measure the position of a plurality of alignment marks distributed over the substrate. These alignment measurements are used during the subsequent exposure of the substrate in order to accurately form the image on the substrate.

It may be desirable to provide new systems and/or new methods to enable such alignment measurements that at least partially address one or more problems associated with prior art arrangements, whether such problems are disclosed herein or otherwise.

### SUMMARY

According to a first aspect of the present disclosure there is provided a metrology system for determining a position of a plurality of targets on a substrate, the metrology system comprising: a substrate support for supporting a substrate; a sensor support; a plurality of position sensors supported by the sensor support, wherein each of the plurality of position sensors is operable to: project a radiation beam onto a substrate supported by the substrate support; receive a portion of the radiation beam scattered from a target on the substrate; and generate a measurement signal that is indicative of a position of the target relative to that position sensor; and a processor configured to: receive the measurement signal from each of the plurality of position sensors; and to combine the measurement signals from at least two different of the plurality of position sensors to at least partially correct at least one of the measurement signals for a position error due to a relative movement of the substrate support and the sensor from which the at least one of the measurement signal was received so as to determine a corrected position of the target relative to the substrate support.

The metrology system according to the first aspect of the present disclosure may, for example, form part of an exposure apparatus such as, for example, a lithographic apparatus. The metrology system may be used to measure the position of a plurality of targets on a substrate (for example a resist-coated silicon wafer). In so doing, the metrology system may be used to map a substrate and may be used to improve an alignment between a pattern layer that is about to be imaged onto the substrate and one or more other layers that have previously been formed on the substrate. Each of the plurality of position sensors may be referred to as an alignment sensor.

In use, a substrate (for example a wafer) may be clamped to the substrate support within a lithographic apparatus. Once it has been so clamped, it is desirable to know the position of each of a plurality of alignment targets across the substrate relative to the substrate support. With this information, the lithographic apparatus will know how to position the substrate support during exposure of the substrate in order to achieve alignment of the layer currently being formed to previous layers (by accurately positioning the substrate relative to the patterned exposure radiation).

The metrology system according to the first aspect of the present disclosure is advantageous, as now discussed.

It is desirable to increase the number of alignment targets that are measured. However, such measurements take a non-zero amount of time and therefore increasing the number of alignment targets that are measured can negatively affect the throughput of a lithographic apparatus. Advantageously, the metrology system according to the first aspect of the present disclosure comprises a plurality of position sensors supported by the sensor support, and therefore allows for a plurality of different alignment target measurements to be made simultaneously. This allows the number of alignment targets that are measured to be increased with little or no impact on the throughput of the lithographic apparatus.

In principle, if a relative position of the plurality of sensors and the substrate support are known, a measurement of a position of a target relative to one of the position sensors can be converted into a position of that target relative to a reference position on the substrate support. However, in practice, there may be an error in the relative position of the plurality of sensors and the substrate support, for example, if there is relative movement of the substrate support and the position sensors. If so, this will result in an error in a determined position of the target relative to the substrate support (or a position error) due to this relative movement of the substrate support and the plurality of sensors. The metrology system according to the first aspect of the present disclosure combines measurements from the plurality of position sensors and, advantageously, this allows for these position errors to be at least partially corrected for. In particular, it may allow for one or more eigen modes (or normal modes) of the sensor support to be corrected for, as now discussed.

The sensor support may be subject to time dependent movement, oscillations and distortions. For a linear system, a general movement of the sensor support may be expressed as a linear combination of its eigen modes. Each such eigen mode describes an oscillation of one or more parts of the system at the same frequency (the eigen frequency of that eigen mode) with a fixed phase relationship.

The eigen modes will, in general, depend on the structure of the sensor support, the plurality of sensors, how these are connected to each other, the stiffness of the materials used and the boundary conditions (for example how the sensor support is itself supported or constrained). In principle, all of the eigen modes can be determined through modelling. For each such eigen mode, it can be determined how each of the plurality of position sensors will move (for example relative to the substrate support and/or relative to an intermediate main support) and therefore what impact that eigen mode will have on the measurement signal of each of the plurality of position sensors can be determined. Since each eigen mode describes an oscillation of one or more parts of the system at the same frequency with a fixed phase relationship, there will be a correlation between contribution to the position errors of each of the plurality of position sensors from each eigen mode. This correlation between the position errors of the plurality of position sensors from each eigen mode may be referred to as a fingerprint of that eigen mode. The processor may be operable to combine the measurement signals from at least two different of the plurality of position sensors based on known eigen modes and/or the fingerprints of such eigen modes in such a way so as to at least partially correct for movement of the sensor support due to such eigen modes.

For example, over time a relative position of the sensor head as a whole (relative to the substrate support) may vary. This may manifest as a time dependent contribution to the determined positions that is the same for all of the plurality of position sensors. If such an identical contribution to the determined positions of all of the plurality of position sensors is identified the processor may correct for it. One or more characteristic or eigen frequencies for one or more relative movements (for example in multiple directions) may be known and the processor may use these to identify such an identical contribution to the determined positions of all of the plurality of position sensors.

Additionally or alternatively, over time a relative orientation of the sensor head as a whole (relative to the substrate support) may vary. This may manifest as time dependent contributions to the determined positions, wherein there is a correlation between a position of each of the plurality of position sensors on the sensor support (for example relative to an axis of rotation of that eigen mode) and a magnitude of the contribution. Additionally or alternatively, over time the sensor head may undergo distortions. Again, this may manifest as time dependent contributions to the determined positions, wherein there is a correlation between a position of each of the plurality of position sensors on the sensor support and a magnitude of the contribution. If such correlated contributions to the determined positions of all of the plurality of position sensors are identified the processor may correct for these. One or more characteristic or eigen frequencies for one or more relative movements (for example in multiple directions) may be known and the processor may use these to identify such correlated contributions to the determined positions of all of the plurality of position sensors.

Note that a "position error" due to a relative movement of the substrate support and the sensor from which the at least one of the measurement signal was received is intended to mean a contribution to the measurement signal(s) due to an unknown or unintentional relative movement of the substrate support and the position sensors. Such unintentional relative movement of the substrate support and the positions sensors may include some time-dependent drift in the relative positions and/or orientations of the substrate support and the position sensors.

As discussed further below, in practice the measurement signals may be generated during a scan in which there is (an intentional and known) relative movement of the substrate support and the sensor support, for example at a constant scan velocity. Note that such intentional relative movement at a constant scan velocity will give rise to a contribution to the measurement signals of all of the plurality of position sensors at a known frequency. A "position error" due to a relative movement of the substrate support and one of the position sensors is not intended to include a contribution to the measurement signal from such a clear and known frequency contribution due to an intentional or known relative movement (which can be distinguished from the position signal without reference to the measurement signal of at least one different one of the plurality of position sensors).

Note that as used herein, unless expressly stated, the term "radiation" is not intended be limited to electromagnetic radiation. Furthermore, as used herein, unless expressly stated, the term "radiation" is not intended be limited to ionizing radiation. In general, radiation may include any propagation of energy such as, for example, electromagnetic radiation or a beam of charged particles (such as, for example, electrons or protons).

Furthermore, it will be appreciated that each the plurality of position sensors may be suitable for detecting or sensing radiation of the radiation beam. For example, for embodiments wherein the radiation beam comprises electromagnetic radiation each the plurality of position sensors may be suitable for detecting such electromagnetic radiation. Similarly, for embodiments wherein the radiation beam comprises a beam of charged particles each the plurality of position sensors may comprise an appropriate charged particle detector.

The processor may be configured, for at least one of the plurality of position sensors, to use the measurement signals from at least one different one of the plurality of position sensors to at least partially correct the measurement signal of that position sensor for a position error due to a relative movement of the substrate support and the sensor from which the at least one of the measurement signal was received so as to determine a corrected position of the target relative to the substrate support.

For example, the position error of one position sensor at a particular eigen frequency may be determined or estimated based on position errors of one or more other positions sensors at the same eigen frequency.

The processor may be configured to at least partially correct the measurement signal of at least one position sensor for a time-dependent position error due to a relative movement of the substrate support and the sensor from which the at least one of the measurement signal was received.

In some embodiments, the substrate support may be scanned relative to the sensor support (or vice versa) while a measurement signal is determined using each of the plurality of position sensors. With such embodiments, the measurement signals may each oscillate with a frequency that is dependent on a relative scan speed of the substrate support and the sensor support and a pitch of the target.

The metrology system may further comprise a movement mechanism operable to cause relative movement of the substrate support and the sensor support.

For example, the substrate support may comprise a wafer stage that is movable relative to the sensor support.

Each of the plurality of position sensors may comprise a self-referencing interferometer that may be operable to receive at least two diffraction beams scattered from the target on the substrate and to spatially overlap these so that they mutually interfere and the measurement signal may be generated from said interference.

The radiation beam projected onto the substrate by each of the plurality of position sensors may be so projected at generally normal incidence. The targets may comprise a diffraction grating or the like. The targets may generate a plurality of angularly separate diffraction beams from the radiation beam projected there onto by one of the plurality of position sensors. It will be appreciated that the relative phases of the plurality of angularly separate diffraction beams are dependent on a position of the beam spot of the radiation beam projected onto the target relative to the target. Furthermore, as the beam spot of the radiation beam projected onto the target and/or the target move relative to each other, the relative phases of different diffraction beams will oscillate. If two or more diffraction beams are combined, an intensity of the radiation will oscillate as the beam spot of the radiation beam projected onto the target and/or the target move relative to each other. This oscillating signal may be detected by a radiation sensitive detector and a position of the target (relative to that position sensor) may be determined from a phase of this oscillating signal.

Alternatively, in some other embodiments, the plurality of position sensors may comprise any other type of position sensor (for example not using a self-referencing interferometer).

The metrology system may further comprise a main support. The sensor support may be supported by the main support.

The sensor support may be supported by the main support either directly or indirectly via one or more intermediate supports.

The sensor support may be rigidly connected to the main support.

Again, the sensor support may be rigidly connected to the main support either directly or indirectly via one or more intermediate supports.

The metrology system may further comprise at least one sensor measurement system that is operable to determine a position and/or an orientation of at least one of the plurality of sensors relative to the main support.

The at least one sensor measurement system may be operable to determine an orientation or pointing direction of at least one of the plurality of sensors relative to the main support. For example, the at least one sensor support measurement system may be operable to determine an orientation of an objective lens of at least one of the plurality of sensors relative to the main support.

Each sensor may be used to measure a position of a plurality of alignment targets on a substrate. These measurements may, for example, subsequently be used during exposure of the substrate to patterned radiation, to ensure that the patterned radiation is well-aligned to one or more previously formed patterns. Therefore, each of the plurality of position sensors may be referred to as an alignment sensor. Such a sensor measurement system may be referred to as an alignment reference axis (ARA) measurement.

The processor may be operable to: receive at least one sensor signal that is indicative of position and/or an orientation of one of the plurality of sensors relative to the main support; and use the or each sensor signal to apply a correction to the measurement signal received from a corresponding position sensor before the measurement signals are combined to at least partially correct the measurement signal of the at least one of the plurality of position sensors for a position error due to a relative movement of the substrate support and the position sensor(s).

The substrate support may be movable relative to the main support.

The metrology system may further comprise at least one substrate support measurement system that is operable to determine a position and/or an orientation of the substrate support relative to the main support.

The at least one substrate support measurement system may comprise one or more interferometers. For example, the one or more interferometers may be supported by the main frame. The at least one substrate support may comprise one or more reflective surfaces or mirrors and one arm or branch of the or each interferometer may be comprise a radiation beam (for example a laser beam) that is reflected from one of the one or more reflective surfaces or mirrors.

Alternatively, in other embodiments the at least one substrate support measurement system may use grid plates and encoders.

The substrate support may be referred to as a stage or a wafer stage. Such a substrate support measurement system may be referred to as a stage position measurement (SPM).

The processor may be operable to: receive a substrate support signal that is indicative of position and/or an orientation of the substrate support relative to the main support; and use the sensor support signal to apply a correction to the measurement signals received from the plurality of position sensors before they are combined to at least partially correct the measurement signal of the at least one of the plurality of position sensors for a position error due to a relative movement of the substrate support and the position sensor(s).

At least one of the plurality of position sensors may be movable relative to the sensor support.

In some embodiments all of the plurality of position sensors may be movable relative to the sensor support. In some embodiments all of the plurality of position sensors except one position sensor may be movable relative to the sensor support. That is, the plurality of position sensors may be independently movable relative to each of the other position sensors.

Advantageously, such an arrangement may allow for the size of a field defined on the substrate to be adjusted, as now discussed. In use, the metrology system may be used to within a lithographic apparatus to determine the position of a plurality of marks on a substrate. Alternatively, the metrology system may be used as part of a separate tool (for example to determine the position of a plurality of marks on a substrate before the substrate is loaded into a lithographic apparatus). Such a lithographic apparatus may be used to form an image of a pattern on a plurality of target regions of a substrate (for example a resist-coated silicon wafer). Each such target region may be referred to as a field and, in general, there may be small gaps between adjacent target regions known as scribe lanes. It will be appreciated that the plurality of position sensors may, in use, be used to simultaneously measure the position of a plurality of targets on a substrate. Such targets may, for example, each be formed in one of the scribe lanes so as not affect the image formed in the field. By allowing the at least one of the plurality of position sensors to be movable relative to the sensor support, a user of the lithographic apparatus can vary a distance between the position sensors and therefore allow the simultaneous measurements to be made for different field widths, which provides more flexibility of a user of the lithographic apparatus.

The processor may be configured to combine the measurement signals from at least two different of the plurality of position sensors so as to at least partially correct at least one of the measurement signals for a position error due to one or more eigen modes of the sensor support.

The plurality of position sensors may be arranged in a line extending in a first direction. Each of the plurality of position sensors may be arranged to project its radiation beam in a second direction so as to be incident on the substrate. The one or more eigen modes of the sensor support may comprise a rotation of the sensor support around an axis of rotation that is generally parallel to the second direction.

The plurality of position sensors may be arranged substantially equally distanced along the first direction. The axis of rotation may, for example, be aligned with a center position sensor of the plurality of position sensors.

The processor may be configured to: perform a fitting process on the measurement signals from at least two different of the plurality of position sensors to determine one or more correlated position errors common to all of the at least two different of the plurality of position sensors; and to use the determined one or more correlated position errors to at least partially correct the measurement signals of at least one of the at least two different of the plurality of position sensors.

The fitting process may comprise elements of machine learning and/or artificial intelligence. The fitting process may comprise a dimensionality reduction technique such as, for example principal component analysis (PCA) and/or linear discriminant analysis (LDA).

According to a second aspect of the present disclosure there is provided an exposure apparatus comprising the metrology system of the first aspect of the present disclosure.

The exposure apparatus according to the second aspect of the present disclosure is advantageous as it can benefit from the parallel measurements and reduced position errors that result from the metrology system according to the first aspect of the present disclosure.

The exposure apparatus may comprise: a patterning device support operable to support a patterning device; an illumination system operable to illuminate a patterning device supported by the patterning device support with exposure radiation; and imaging optics arranged to form an image of the patterning device on a substrate supported by the substrate support using the exposure radiation.

At least one corrected position of a target relative to the substrate support as determined by the processor may be used to position the substrate support during the formation of the image.

According to a third aspect of the present disclosure there is provided a method for determining a correction for a position measurement, the method comprising: using a plurality of position sensors supported by a sensor support to: project a radiation beam onto a substrate supported by a substrate support; receive a portion of the radiation beam scattered from a target on the substrate; and generate a measurement signal that is indicative of a position of the target relative to that position sensor; and combining the measurement signals from at least two different of the plurality of position sensors to determine a correction for at least one of the measurement signals for a position error due to a relative movement of the substrate support and the sensor from which the at least one of the measurement signal was received.

The method according to the third aspect of the present disclosure may be carried out using the metrology system according to the first aspect of the present disclosure. The method according to the third aspect of the present disclosure may comprise any combination of the features of the metrology system according to the first aspect of the present disclosure. The method according to the third aspect of the present disclosure is advantageous for the reasons discussed above with reference to the first aspect of the present disclosure.

The method may comprise: identifying at least one eigen mode of the sensor support; for the or each at least one identified eigen mode, determining a correlation between a contribution to the position errors of each of the plurality of position sensors; for each eigen mode identifying a signal from the measurement signals from at least two different of the plurality of position sensors corresponding to the identified correlation between a contribution to the position errors of each of the plurality of position sensors; and determining the correction for at least one of the measurement signals in dependence on the or each identified signal.

The correction may be for at least partially correcting the measurement signal of at least one position sensor for a time-dependent position error due to a relative movement of the substrate support and the sensor from which the at least one of the measurement signals was received.

The method may further comprise moving the substrate support relative to the sensor support or vice versa while the measurement signals are being generated.

For example, the substrate support may comprise a wafer stage that is movable relative to the sensor support.

Each of the plurality of position sensors may comprise a self-referencing interferometer that is operable to receive at least two diffraction beams scattered from the target on the substrate and to spatially overlap these so that they mutually interfere. The measurement signal(s) may be generated from said interference.

The sensor support may be supported by a main support. The method may further comprise: determining a position and/or an orientation of at least one of the plurality of sensors relative to the main support; and using the determined position and/or an orientation of at least one of the plurality of sensors relative to the main support to apply a correction to the measurement signal received from a corresponding position sensor before the measurement signals are combined to determine the correction for the at least one of the measurement signals.

Such a correction based on the determined position and/or an orientation of at least one of the plurality of sensors relative to the main support may be determined by a sensor measurement system and may be referred to as an alignment reference axis (ARA) correction.

The method may further comprise: determining a position and/or an orientation of the substrate support relative to the main support; and using the determined position and/or an orientation of the substrate support relative to the main support to apply a correction to the measurement signals received the plurality of position sensors before the measurement signals are combined to determine the correction for the at least one of the measurement signals.

The substrate support may be referred to as a stage or a wafer stage. Such a correction based on the determined position and/or an orientation of the substrate support relative to the main support may be referred to as a stage position measurement (SPM).

The correction may be for at least partially correcting at least one of the measurement signals for a position error due to one or more eigen modes of the sensor support.

Determining the correction may comprise: performing a fitting process on the measurement signals from at least two different position sensors of the plurality of position sensors to determine one or more correlated position errors common to all of the at least two different position sensors of the plurality of position sensors; and using the determined one or more correlated position errors to determine a correction for the measurement signals of at least one of the at least two different position sensors of the plurality of position sensors.

The fitting process may comprise elements of machine learning and/or artificial intelligence. The fitting process may comprise a dimensionality reduction technique such as, for example principal component analysis (PCA) and/or linear discriminant analysis (LDA).

According to a fourth aspect of the present disclosure there is provided a method for determining a position of a plurality of targets on a substrate, the method comprising: determining the correction for at least one of the measurement signals for a position error due to a relative movement of the substrate support and the sensor from which the at least one of the measurement signal was received using the method of the third aspect of the present disclosure; and applying the or each correction so as to correct the at least one of the measurement signals for said position error.

Features of different aspects of the invention may be combined together, where the person skilled in the art deems it to be appropriate.

### BRIEF DESCRIPTION OF THE DRAWINGS

Embodiments of the invention will now be described, by way of example only, with reference to the accompanying schematic drawings, in which:
- Figure 1 schematically depicts a lithographic system comprising a lithographic apparatus and a substrate table according to an embodiment of the present disclosure;

Figure 2 schematically shows an alignment system for analyzing alignment marks;
Figure 3 schematically shows an arrangement wherein an alignment system (which may, for example, be of the form of the alignment system shown in Figure 2) may be used to determine a position of alignment marks on a substrate relative to a substrate stage WT;
Figure 4 schematically shows a metrology system for determining a position of a plurality of targets on a substrate according to an embodiment of the present disclosure;
Figure 5 schematically shows a specific embodiment of the new metrology system shown schematically in Figure 4 with some additional optional features;
Figure 6A shows a schematic side view of the plurality of position sensors of the metrology system shown in Figure 4 and 5 in an x-z plane (a similar view to that shown in Figures 4 and 5); also shown is a section of the substrate;
Figure 6B shows a schematic top view of the plurality of position sensors of the metrology system shown in Figure 4 and 5 in an x-y plane; also shown is a section of the substrate;
Figure 7 schematically shows an arrangement similar to that shown in Figure 6B wherein the plurality of position sensors have rotated about the axis of rotation from a nominal position (as shown in Figure 6B); also shown in dashed lines in Figure 7 is a nominal position of each of the plurality of position sensors and a nominal position of the central or chief ray of the radiation projected onto the substrate by each of the position sensors;
Figure 8 schematically shows a new method for determining a correction for a position measurement according to an embodiment of the present disclosure;
Figure 9 schematically shows a specific embodiment of the new method shown schematically in Figure 8 with some additional optional features; and
Figure 10 schematically shows a new method for determining a position of a plurality of targets on a substrate according to an embodiment of the present disclosure.

### DETAILED DESCRIPTION

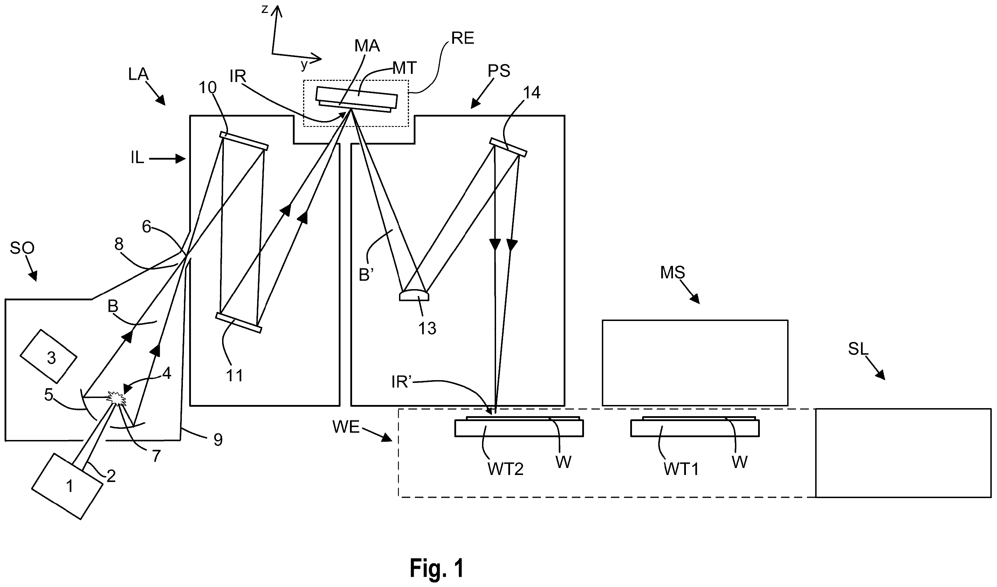

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g. a mask), a projection system PS, a measurement system MS, and a substrate loading system SL. The support structure MT may be referred to as a patterning device support MT. The lithographic system further comprises two substrate tables WT1, WT2 which are each configured to support a substrate W. Each substrate table WT1, WT2 may be referred to as a substrate support WT1, WT2. The support structure MT and the two substrate tables WT1, WT2 may each comprise a clamp, for example an electrostatic clamp.

Note that as used herein, the term substrate W is intended to mean any substrate which may be exposed to a a patterned radiation beam. For example, such a substrate W may comprise a restist-coated silicon wafer. Alternatively, such a substrate W may comprise a glass substrate (also known in the art as "panels"). Such glass substrates may, for example be generally rectangular.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11. In general, the illumination system IL is configured to control an angular and spatial intensity distribution at the patterning device MA.

After being thus conditioned, the EUV radiation beam B interacts with the patterning device MA. As a result of this interaction, a patterned EUV radiation beam B' is generated. The projection system PS is configured to project the patterned EUV radiation beam B' onto a substrate W. For that purpose, the projection system PS may comprise a plurality of mirrors 13, 14 which are configured to project the patterned EUV radiation beam B' onto a substrate W held by one or the substrate tables WT1, WT2 when that substrate table is disposed in an exposure region (in Figure 1 substrate table WT2 is positioned in the exposure region). The projection system PS is configured to form an image of the patterning device (for example a diffraction limited image) on a substrate W supported by one of the two substrate tables WT1, WT2 disposed in an exposure region. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g., six or eight mirrors).

The faceted field mirror device 10 and the faceted pupil mirror device 11 are arranged to provide a desired angular distribution of the radiation beam B, at the patterning device MA, as well as a desired uniformity of radiation intensity at the patterning device MA. The illumination system IL may be arranged to provide Kohler illumination of an illumination region IR (that the patterning device MA may be moved through during exposure of a substrate W) such that the plasma at the plasma formation region 4 is out of focus (and therefore does not influence properties of the radiation beam) at the patterning device MA and in the conjugate plane of the substrate W. As used herein, the illumination region IR may also be referred to as the illumination slit or the slit.

The illumination region IR is in a field plane in which the reticle MA is disposed during a lithographic exposure. Therefore, the illumination region IR may be referred to as a reticle-level or object-level illumination region IR. The reticle-level illumination region IR may be referred to as a first illumination region IR. It will be appreciated that projection system PS forms an image IR' of the illumination region IR in the plane of the substrate W. The image IR' of the illumination region IR in the plane of the substrate W may be referred to as a wafer-level or image-level illumination region IR'. As used herein, the wafer-level illumination region IR' may also be referred to as the slit. The wafer-level illumination region IR' may be referred to as a second illumination region IR.

The lithographic apparatus LA may be a scanning lithographic apparatus (also referred to as a scanner) and the image (of a reticle MA) may be formed during a scanning exposure. In such an exposure, the reticle MA may be moved in a scanning direction through the reticle-level illumination region IR. It will be appreciated that, as a result of this movement of the reticle MA, the image of the reticle MA will move at wafer level. Therefore, during the scanning exposure, the wafer W is also moved through the wafer-level illumination region IR'. In particular, the wafer W is moved so that the image of reticle MA is substantially static with respect to the wafer W. The movement of the reticle MA and the substrate W are therefore synchronized. The movement (speed and direction) of the substrate W will be dependent on the movement of the reticle and the imaging performed by the projection system PS. In some embodiments, the projection system PS may form an inverted image of the reticle MA and therefore the substrate W may be moved in an opposite direction to the reticle MA. In some embodiments, the projection system PS may apply a reduction factor to the patterned EUV radiation beam B' in the scanning direction and therefore the substrate W may move at a speed that is smaller than the speed of the reticle MA by this reduction factor.

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the environment of the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at the intermediate focus 6 to form an image at the intermediate focus 6 of the plasma 7 present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The measurement system MS of the lithographic apparatus is configured to perform measurements of properties of a substrate W held on one of the two substrate tables WT1, WT2 when that substrate table is disposed in a metrology region (in Figure 1 substrate table WT1 is positioned in the metrology region). The metrology region may alternatively be referred to as an intermediate metrology region. The measurement system MS may comprises an alignment system, which is configured to measure the positions of alignment marks on the substrate with reference to alignment marks on the substrate table WT1. Additionally or alternatively, the measurement system MS may comprise a level sensor which is configured to measure the topography of the substrate W. These measured properties are used to ensure accuracy when a pattern is subsequently projected onto the substrate W.

The two substrate tables WT1, WT2 may both be disposed in a wafer environment WE. Each of the two substrate tables WT1, WT2 may be movable within the wafer environment WE, as discussed further below. In particular, the substrate tables WT1, WT2 may each be positionable in an exposure region (see, for example, substrate table WT2 in Figure 1) and a metrology region (see, for example, substrate table WT1 in Figure 1).

The lithographic apparatus LA is a dual-stage lithographic apparatus. That is, the lithographic apparatus includes two substrate tables WT1, WT2 and is configured such that a substrate W held on one of the substrate tables WT1 is measured by the measurement system MS simultaneously with a pattern being applied to a substrate W held on the other substrate table WT2. For ease of terminology, one of the substrate tables WT1 may be referred to as a first substrate table, and the other substrate table WT2 may be referred to as a second substrate table. Dual-stage lithographic apparatus advantageously provide higher throughput (i.e. exposure of substrates per hour) than single stage lithographic apparatus. Once the substrate W held on the first substrate table WT1 has been measured, and the substrate W held on the second substrate table WT2 has been exposed, the substrate table WT1 supporting the measured substrate W is moved to be beneath the projection system PS. At the same time, the exposed substrate W supported by the second substrate table WT2 is moved to the substrate loading system SL.

The substrate loading system SL includes a substrate handler (not depicted) which is configured to remove the patterned substrate W from one of the substrate tables WT1, WT2 when that substrate table is disposed in a loading/unloading region and then load a new substrate to be patterned onto that substrate table. Once the substrate has been loaded onto the substrate table, the measurement system MS may be used to measure alignment mark positions and the topology of the substrate. Simultaneously, the substrate W held on the other substrate table (which is disposed in an exposure region) is exposed by the lithographic apparatus LA.

The above method may be repeated many times in order to expose many substrates W using the lithographic apparatus LA.

Integrated circuits (ICs) are built up layer by layer, and modern ICs can have 30 or more layers. On Product Overlay (OPO) is a measure of a system's ability to print these layers accurately on top of each other. Successive layers or multiple processes on the same layer must be accurately aligned to the previous layer. Otherwise, electrical contact between structures will be poor and the resulting devices will not perform to specification. Good overlay improves device yield and enables smaller product patterns to be printed. The overlay error between successive layers formed in or on the patterned substrate is controlled by various parts of the exposure apparatus of the lithographic apparatus.

Process-induced wafer errors are a significant impediment to OPO performance. Process-induced wafer errors are attributable to the complexity of printed patterns as well as an increase of the number of printed layers. This error is of relatively high spatial variation that is different from wafer to wafer, and within a given wafer.

In order to control the lithographic process to place device features accurately on the substrate, one or more alignment marks are generally provided on, for example, the substrate, and the lithographic apparatus includes one or more alignment sensors by which the position of the mark may be measured accurately. The alignment sensor may be effectively a position measuring apparatus. Different types of marks and different types of alignment sensors are known from different times and different manufacturers. Measurement of the relative position of several alignment marks within the field can correct for process-induced wafer errors. Alignment error variation within the field can be used to fit a model to correct for OPO within the field

Lithographic apparatus are known to use various alignment systems to align the substrate with respect to the lithographic apparatus. The data can for example be obtained with any type of alignment sensor. A first example is a SMASH (SMart Alignment Sensor Hybrid) sensor, as described in U.S. Pat. No. 6,961,116, issued Nov. 1, 2005 and titled "Lithographic Apparatus, Device Manufacturing Method, and Device Manufactured Thereby," which is hereby incorporated by reference herein in its entirety, and which employs a self-referencing interferometer with a single detector and four different wavelengths and extracts the alignment signal in software. A second example is an ATHENA (Advanced Technology using High order ENhancement of Alignment) sensor, as described in U.S. Pat. No. 6,297,876, issued Oct. 2, 2001 and titled "Lithographic Projection Apparatus with an Alignment System for Aligning Substrate on Mask," which is hereby incorporated by reference in its entirety, and which directs each of seven diffraction orders to a dedicated detector. A third example is an ORION sensor, which uses multiple polarizations per available signal (color).

Reference is made in particular to the European application No. EP 1 372 040 A1, granted Mar. 5, 2008 and titled "Lithographic Apparatus and Device Manufacturing Method", which document is hereby incorporated by reference in its entirety. EP 1 372 040 A1 describes an alignment system using a self-referencing interferometer that produces two overlapping images of an alignment marker. These two images are rotated over 180° with respect to each other. EP 1 372 040 A1 further describes the detection of the intensity variation of the interfering Fourier transforms of these two images in a pupil plane. These intensity variations correspond to a phase difference between different diffraction orders of the two images, and from this phase difference positional information is derived, which is required for the alignment process. Reference is also made to U.S. Pat. No. 8,610,898, "Self-Referencing Interferometer, Alignment System, and Lithographic Apparatus" issued Dec. 17, 2013, the entire contents of which are hereby incorporated by reference in their entirety.

Such alignment sensors typically measure alignment marks in the form of scribe lane marks to determine a position of each mark. A wafer grid is determined from these mark positions. An accurate wafer grid reduces the potential for overlay errors.

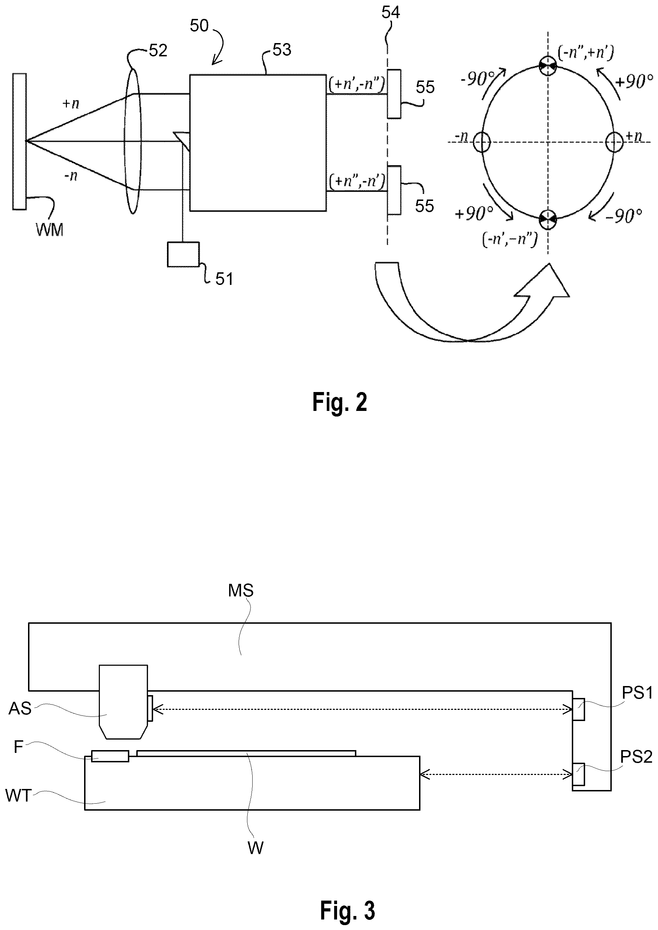

Figure 2 shows a schematic overview of a known alignment system 50. A light source 51 emits a spatially coherent beam of radiation which illuminates an alignment marker WM on a substrate (e.g., a wafer), which scatters the radiation into positive and negative diffraction orders +n and -n. These diffraction orders are collimated by an objective lens 52 and enter a self-referencing interferometer (SRI) 53. The self-referencing interferometer outputs two images of the input, which have a relative rotation of 180°, and which overlap and which can therefore be made to interfere. In a pupil plane 54, the overlapping Fourier transforms of these images can be seen and be made to interfere (the different diffraction orders being separated in this pupil plane 54). Detectors 55 in the pupil plane detect the interfered diffraction orders to provide position information. Based on this position information a substrate can be aligned accurately with respect to a lithographic apparatus. The right-hand part of Figure 2 shows the formation of two overlapping images in the pupil plane 54; for one image +n' and -n' are rotated by +90° relative to the input diffraction orders +n and -n; for the other image +n" and -n" are rotated by -90° relative to the input diffraction orders +n and -n. In the pupil plane the orders of respectively (+n' and -n"), and (+n" and -n') interfere.

The output of a sensor such as that just described is typically relayed to a detector that detects the pattern of intensities in the sensor output. In the alignment sensor the output sensor (a single pixel detector) detects the intensity variation arising from the interference between the + order and - order. This interference creates two channels, a SUM channel in which the electric fields are added and a DIFF channel in which the electric fields are subtracted. These two channels are 180 degrees out of phase with each other. The alignment position of the mark is computed by measuring the phase of the signal at the DIFF or SUM or a combination of the two channels. In such systems all of the light is directed to the detector.

Figure 3 schematically shows an arrangement wherein an alignment system AS (which may, for example, be of the form of the alignment system 50 shown in Figure 2) may be used to determine a position of alignment marks on a substrate W relative to a substrate stage WT. The alignment system AS may be supported by a main support MS. The alignment system AS may be used to determine a position of a mark (on either a substrate W or a fiducial F) relative to the alignment sensor AS The alignment system AS may be used to determine a position of a mark (on either a substrate W or a fiducial F) relative to the alignment sensor AS.

A first position sensor PS1 is operable to determine an orientation or pointing direction of the alignment sensor AS relative to the main support MS. For example, the first position sensor PS1 may be operable to determine an orientation of an objective lens of the alignment sensor AS relative to the main support MS. Such a measurement (made by the first positon sensor PS1) may be referred to as an alignment reference axis (ARA) measurement.

A second position sensor PS2 is operable to determine a position and/or an orientation of the substrate support WT relative to the main support MS. The second position sensor PS2 may comprise one or more interferometers. For example, the one or more interferometers may be supported by the main support MS. The substrate support WT may comprise one or more reflective surfaces or mirrors and one arm or branch of the or each interferometer may be comprise a radiation beam (for example a laser beam) that is reflected from one of the one or more reflective surfaces or mirrors. Alternatively, the second position sensor PS2 may comprise one or more grid plates and encoders. Such a measurement (made by the second positon sensor PS2) may be referred to as stage position measurement (SPM).

The alignment system AS may be used to determine a position of a mark (on either a substrate W or a fiducial F) relative to the alignment sensor AS. Using the measurements from the first and second positions sensors, this may be converted into a position of the mark relative to the substrate support WT.

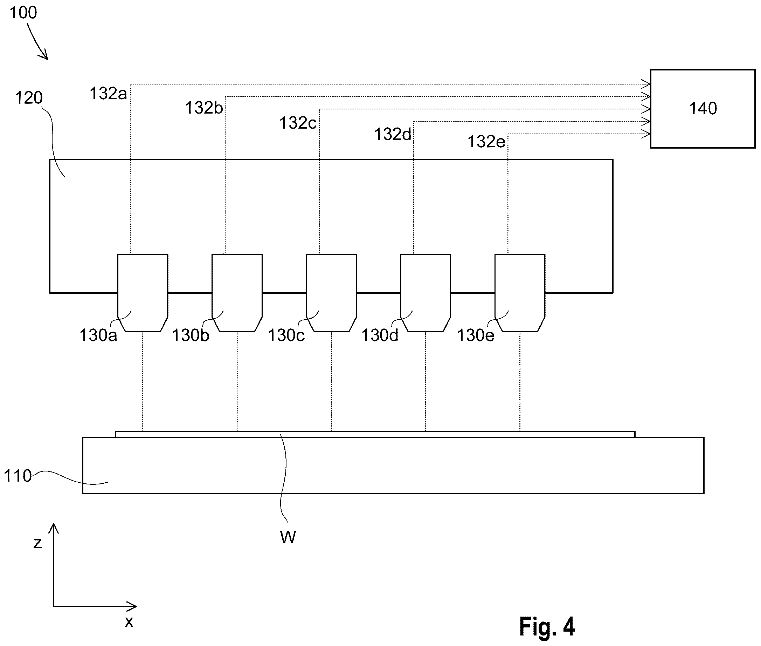

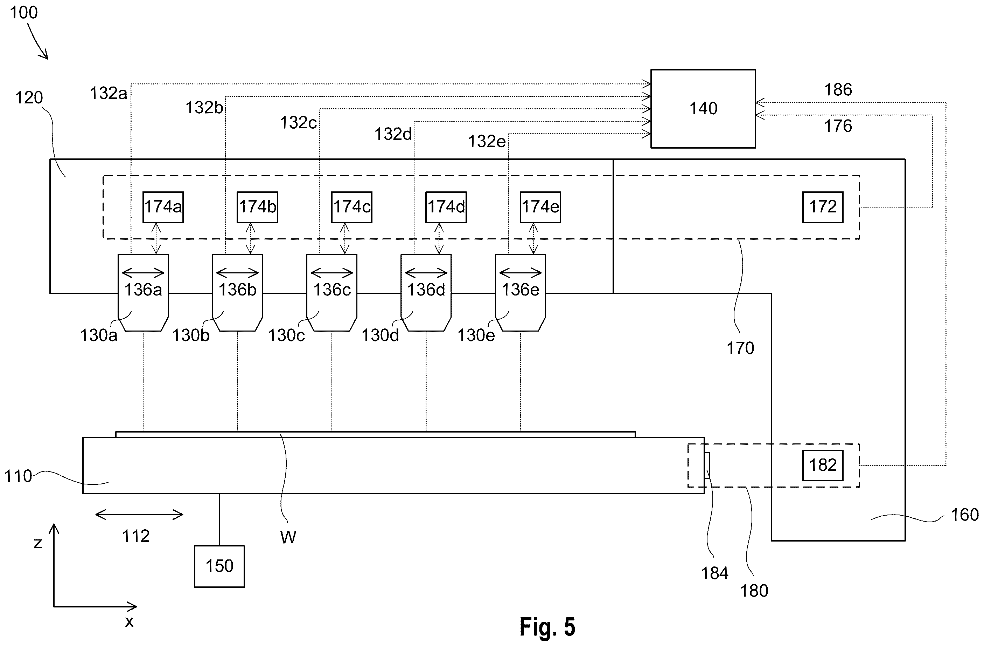

Some embodiments of the present disclosure relate to a metrology system for determining a position of a plurality of targets on a substrate. As example of such a new metrology system 100 is shown schematically in Figure 4 and is now described. Figure 5 schematically shows a specific embodiment of the new metrology system 100 shown schematically in Figure 4 with some additional optional features.

The metrology system 100 comprises: a substrate support 110; a sensor support 120; a plurality of position sensors 130a-130e; and a processor 140. In Figure 4, metrology system 100 is shown comprising five position sensors 130a-130e. However, it will be appreciated that the metrology system may have fewer than, or more than, 5 position sensors 130a-130e.

The substrate support 110 is suitable for supporting a substrate W (for example a resist-coated silicon wafer or a glass substrate or panel). The substrate support 110 may be generally of the form of one of the substrate tables WT1, WT2 shown in Figure 1 and described above. The substrate support 110 may comprise a clamp, for example an electrostatic clamp.

The plurality of position sensors 130a-130e are supported by the sensor support 120. Each of the plurality of position sensors 130a-130b is operable to: project a radiation beam onto a substrate W supported by the substrate support 110; receive a portion of the radiation beam scattered from a target on the substrate 110; and generate a measurement signal 132a-132e that is indicative of a position of the target relative to that position sensor 130a-130e.

Note that the radiation beam projected onto the substrate W by the position sensors 130a-130b may be of any type of radiation such as, for example, electromagnetic radiation or a beam of charged particles (such as, for example, electrons or protons). Furthermore, it will be appreciated that each the plurality of position sensors 130a-130b may be suitable for detecting or sensing radiation of the radiation beam (so as to generate the measurement signal 132a-132e in dependence thereon).

The processor 140 is configured to: receive the measurement signal 132a-132e from each of the plurality of position sensors 130a-130e.

The processor 140 is further configured to combine the measurement signals 132a-132e from at least two different of the plurality of position sensors 130a-130e to at least partially correct at least one of the measurement signals 132a-132e for a position error due to a relative movement of the substrate support 120 and the sensor 130a-130e from which the at least one of the measurement signal 132a-132e was received so as to determine a corrected position of the target relative to the substrate support 110.

The metrology system 100 shown in Figure 4 may, for example, form part of an exposure apparatus such as, for example, a lithographic apparatus LA of the type shown in Figure 1. The metrology system 100 may be used to measure the position of a plurality of targets on a substrate W (for example a resist-coated silicon wafer). In so doing, the metrology system 100 may be used to map a substrate W and may be used to improve an alignment between a pattern layer that is about to be imaged onto the substrate W and one or more other layers that have previously been formed on the substrate W. Each of the plurality of position sensors 130a-130e may be referred to as an alignment sensor.

In use, a substrate W (for example a wafer) may be clamped to the substrate support 110 within a lithographic apparatus LA. Once it has been so clamped, it is desirable to know the position of each of a plurality of alignment targets across the substrate W relative to the substrate support 110. With this information, the lithographic apparatus LA will know how to position the substrate support 110 during exposure of the substrate W in order to achieve alignment of the layer currently being formed to previous layers (by accurately positioning the substrate W relative to the patterned exposure radiation B').

The metrology system 100 shown in Figure 4 is advantageous, as now discussed.

It is desirable to increase the number of alignment targets that are measured. However, such measurements take a non-zero amount of time and therefore increasing the number of alignment targets that are measured can negatively affect the throughput of a lithographic apparatus. Advantageously, the metrology system 100 shown in Figure 4 comprises a plurality of position sensors 130a-130e supported by the sensor support 120, and therefore allows for a plurality of different alignment target measurements to be made simultaneously. This allows the number of alignment targets that are measured to be increased with little or no impact on the throughput of the lithographic apparatus LA.

In principle, if a relative position of the plurality of sensors 130a-130e and the substrate support 110 are known, a measurement of a position of a target relative to one of the position sensors 130a-130e can be converted into a position of that target relative to a reference position on the substrate support 110. Such a reference position may be a position of a target on a fiducial 112 supported by the substrate support 110. However, in practice, there may be an error in the relative position of the plurality of sensors 130a-130e and the substrate support 110, for example, if there is relative movement of the substrate support 110 and the position sensors 130a-130e. If so, this will result in an error in a determined position of the target relative to the substrate support 110 (or a position error) due to this relative movement of the substrate support 110 and the plurality of sensors 130a-130e. The metrology system 100 shown in Figure 4 combines measurements from the plurality of position sensors 130a-130e and, advantageously, this allows for these position errors to be at least partially corrected for. In particular, it may allow for one or more eigen modes (or normal modes) of the sensor support 120 to be corrected for, as now discussed.

The sensor support 120 may be subject to time dependent movement, oscillations and distortions. For a linear system, a general movement of the sensor support 120 may be expressed as a linear combination of its eigen modes. Each such eigen mode describes an oscillation of one or more parts of the system at the same frequency (the eigen frequency of that eigen mode) with a fixed phase relationship.

The eigen modes will, in general, depend on the structure of the sensor support 120, the plurality of sensors 130a-130e, how these are connected to each other, the stiffness of the materials used and the boundary conditions (for example how the sensor support 120 is itself supported or constrained). In principle, all of the eigen modes can be determined through modelling. For each such eigen mode, it can be determined how each of the plurality of position sensors 130a-130e will move (for example relative to the substrate support 120 and/or relative to an intermediate main support) and therefore what impact that eigen mode will have on the measurement signal 132a-132e of each of the plurality of position sensors 130a-130e can be determined. Since each eigen mode describes an oscillation of one or more parts of the system at the same frequency with a fixed phase relationship, there will be a correlation between contribution to the position errors of each of the plurality of position sensors 130a-130e from each eigen mode. This correlation between the position errors of the plurality of position sensors 130a-130e from each eigen mode may be referred to as a fingerprint of that eigen mode. The processor 140 may be operable to combine the measurement signals 132a-132e from at least two different of the plurality of position sensors 130a-130e based on known eigen modes and/or the fingerprints of such eigen modes in such a way so as to at least partially correct for movement of the sensor support 120 due to such eigen modes.

For example, over time a relative position of the sensor support 120 as a whole (relative to the substrate support) may vary. This may manifest as a time dependent contribution to the determined positions that is the same for all of the plurality of position sensors 130a-130e. If such an identical contribution to the determined positions of all of the plurality of position sensors is identified the processor 140 may correct for it. One or more characteristic or eigen frequencies for one or more relative movements (for example in multiple directions) may be known and the processor 140 may use these to identify such an identical contribution to the determined positions of all of the plurality of position sensors 130a-130e.

Additionally or alternatively, over time a relative orientation of the sensor support 120 as a whole (relative to the substrate support) may vary. This may manifest as time dependent contributions to the determined positions, wherein there is a correlation between a position of each of the plurality of position sensors 130a-130e on the sensor support 120 (for example relative to an axis of rotation of that eigen mode) and a magnitude of the contribution. Additionally or alternatively, over time the sensor support 120 may undergo distortions. Again, this may manifest as time dependent contributions to the determined positions, wherein there is a correlation between a position of each of the plurality of position sensors 130a-130e on the sensor support 120 and a magnitude of the contribution. If such correlated contributions to the determined positions of all of the plurality of position sensors are identified the processor 140 may correct for these. One or more characteristic or eigen frequencies for one or more relative movements (for example in multiple directions) may be known and the processor 140 may use these to identify such correlated contributions to the determined positions of all of the plurality of position sensors 130a-130e.

Note that a "position error" due to a relative movement of the substrate support 110 and the sensor 130a-130e from which the at least one of the measurement signal 132a-132e was received is intended to mean a contribution to the measurement signal(s) 132a-132e due to an unknown or unintentional relative movement of the substrate support 110 and the position sensors 130a-130e. Such unintentional relative movement of the substrate support 110 and the position sensors 130a-130e may include some time-dependent drift in the relative positions and/or orientations of the substrate support 110 and the position sensors 130a-130e.

As discussed further below, in practice the measurement signals 132a-132b may be generated during a scan in which there is (an intentional and known) relative movement of the substrate support 110 and the sensor support 120, for example at a constant scan velocity. Note that such intentional relative movement at a constant scan velocity will give rise to a contribution to the measurement signals 132a-132e of all of the plurality of position sensors 130a-130e at a known frequency. A "position error" due to a relative movement of the substrate support 120 and one of the position sensors 130a-130e is not intended to include a contribution to the measurement signal 132a-132e from such a clear and known frequency contribution due to an intentional or known relative movement (which can be distinguished from the position signal without reference to the measurement signal 132a-132e of at least one different one of the plurality of position sensors 130a-130e).

In some embodiments, the processor 140 may be configured, for at least one of the plurality of position sensors 130a, to use the measurement signals 132b-132e from at least one different one of the plurality of position sensors 130b-130e to at least partially correct the measurement signal 132a of that position sensor 130a for a position error due to a relative movement of the substrate support 110 and the sensor 130a from which the at least one of the measurement signal 132a was received so as to determine a corrected position of the target relative to the substrate support 110.

For example, the position error of one position sensor 130a at a particular eigen frequency may be determined or estimated based on position errors of one or more other positions sensors 130b-130e at the same eigen frequency.

In some embodiments, the processor 140 may be configured to at least partially correct the measurement signal 132a-132e of at least one position sensor 130a-130e for a time-dependent position error due to a relative movement of the substrate support 110 and the sensor 130a-130e from which the at least one of the measurement signal 130a-130e was received.

In some embodiments, the substrate support 110 may be scanned relative to the sensor support 120 (or vice versa) while a measurement signal 132a-130e is determined using each of the plurality of position sensors 130a-130e. With such embodiments, the measurement signals 132a-132e may each oscillate with a frequency that is dependent on a relative scan speed of the substrate support 110 and the sensor support 120 and a pitch of the target. Such scanning movement of, for example the substrate support 110, is shown schematically in Figure 5 by arrow 112.

In some embodiments, the metrology system 100 may further comprise a movement mechanism 150 operable to cause relative movement of the substrate support 110 and the sensor support 120. For example, the substrate support 110 may comprise a wafer stage that is movable relative to the sensor support 120.

In some embodiments of the metrology system 100, each of the plurality of position sensors 130a-130e may comprise a self-referencing interferometer that is operable to receive at least two diffraction beams scattered from the target on the substrate W and to spatially overlap these so that they mutually interfere and wherein the measurement signal is generated from said interference. For example, each of the plurality of position sensors 130a-130e may comprise an alignment system 50 of the type shown schematically in Figure 2 (and which comprises a self-referencing interferometer 53).

The radiation beam projected onto the substrate W by each of the plurality of position sensors 130a-130e may be so projected at generally normal incidence. The targets may comprise a diffraction grating or the like. The targets may generate a plurality of angularly separate diffraction beams from the radiation beam projected there onto by one of the plurality of position sensors 130a-130e. It will be appreciated that the relative phases of the plurality of angularly separate diffraction beams are dependent on a position of the beam spot of the radiation beam projected onto the target relative to the target. Furthermore, as the beam spot of the radiation beam projected onto the target and/or the target move relative to each other, the relative phases of different diffraction beams will oscillate. If two or more diffraction beams are combined, an intensity of the radiation will oscillate as the beam spot of the radiation beam projected onto the target and/or the target move relative to each other. This oscillating signal may be detected by a radiation sensitive detector (for example detector 15 shown in Figure 2) and a position of the target (relative to that position sensor) may be determined from a phase of this oscillating signal.

Alternatively, in some other embodiments, the plurality of position sensors 130a-130e may comprise any other type of position sensor (for example not using a self-referencing interferometer).

In some embodiments, the metrology system 100 may further comprise a main support 160. The sensor support 120 may be supported by the main support 160. The sensor support 120 may be supported by the main support 160 either directly or indirectly via one or more intermediate supports (not shown).

In some embodiments, the sensor support 120 may be rigidly connected to the main support 160. Again, the sensor support 120 may be rigidly connected to the main support 160 either directly or indirectly via one or more intermediate supports (not shown).

In some embodiments, the metrology system 100 may further comprise at least one sensor measurement system 170 operable to determine a position and/or an orientation of at least one of the plurality of sensors 130a-130e relative to the main support 160.

The at least one sensor measurement system 170 may be operable to determine an orientation or pointing direction of at least one of the plurality of sensors 130a-130e relative to the main support 160. For example, the at least one sensor measurement system 170 may be operable to determine an orientation of an objective lens of at least one of the plurality of sensors 130a-130e relative to the main support 160.

Each sensor 130a-130b may be used to measure a position of a plurality of alignment targets on a substrate W. These measurements may, for example, subsequently be used during exposure of the substrate W to patterned radiation, to ensure that the patterned radiation is well-aligned to one or more previously formed patterns. Therefore, each of the plurality of position sensors 130a-130e may be referred to as an alignment sensor. Such a sensor measurement system 170 may be referred to as an alignment reference axis (ARA) measurement.

The sensor measurement system 170 may comprise a sensor support measurement system 172 operable to determine a position and/or an orientation of the sensor support 120 relative to the main support 160.

The sensor measurement system 170 may comprise at least one individual sensor measurement system 174a-174e, each operable to determine a position and/or an orientation of one of the plurality of sensors 130a-130e relative to the sensor support 120.

In some embodiments, the processor 140 may be operable to receive at least one sensor signal 176 (from the sensor measurement system 170) that is indicative of position and/or an orientation of one or more of the plurality of sensors 130a-130e relative to the main support 160. The processor 140 may be operable to apply a correction to the measurement signal 132a-132e received from a corresponding position sensor 130a-130e before the measurement signals 132a-132e are combined to at least partially correct the measurement signal(s) 132a-132e of the at least one of the plurality of position sensors 130a-130e for a position error(s) due to a relative movement of the substrate support 110 and the position sensors 130a-130e.

In some embodiments, the substrate support 110 is movable relative to the main support 160 (as indicated in Figure 5 by arrow 112).

In some embodiments, the metrology system 100 may further comprise at least one substrate support measurement system 180 operable to determine a position and/or an orientation of the substrate support 110 relative to the main support 160.

The at least one substrate support measurement system 180 may comprise one or more interferometers 182. For example, the one or more interferometers 182 may be supported by the main frame 160. The at least one substrate support 110 may comprise one or more reflective surfaces or mirrors 184 and one arm or branch of the or each interferometer 182 may be comprise a radiation beam (for example a laser beam) that is reflected from one of the one or more reflective surfaces or mirrors 184.

Alternatively, in other embodiments the at least one substrate support measurement system 180 may use grid plates and encoders.

The substrate support 110 may be referred to as a stage or a wafer stage. Such a substrate support measurement system 180 may be referred to as a stage position measurement (SPM).

The processor 140 may be operable to: receive a substrate support 186 signal that is indicative of position and/or an orientation of the substrate support 110 relative to the main support 160. The processor 140 may be further operable to: use the sensor support signal 186 to apply a correction to the measurement signals 132a-132e received from the plurality of position sensors 130a-130e before they are combined to at least partially correct the measurement signal 132a-132e of the at least one of the plurality of position sensors 130a-130e for a position error due to a relative movement of the substrate support 110 and the position sensor(s) 130a-130e.

In some embodiments, at least one of the plurality of position sensors 130a-130e may be movable relative to the sensor support 120. This is indicated in Figure 5 by arrows 136a-136e.

In some embodiments all of the plurality of position sensors 130a-130e may be movable relative to the sensor support 120. In some embodiments all of the plurality of position sensors 130a-130e except one position sensor may be movable relative to the sensor support 120. That is, the plurality of position sensors 130a-130e may be independently movable relative to each of the other position sensors 130a-130e.

Advantageously, such an arrangement may allow for the size of a field defined on the substrate W to be adjusted, as now discussed. In use, the metrology system 100 may be used to within a lithographic apparatus LA to determine the position of a plurality of marks on a substrate W. Alternatively, the metrology system may be used as part of a separate tool (for example to determine the position of a plurality of marks on a substrate W before the substrate W is loaded into a lithographic apparatus LA). Such a lithographic apparatus LA may be used to form an image of a pattern MA on a plurality of target regions of a substrate W (for example a resist-coated silicon wafer). Each such target region may be referred to as a field and, in general, there may be small gaps between adjacent target regions known as scribe lanes. It will be appreciated that the plurality of position sensors may, in use, be used to simultaneously measure the position of a plurality of targets on a substrate W. Such targets may, for example, each be formed in one of the scribe lanes so as not affect the image formed in the field. By allowing the at least one of the plurality of position sensors 130a-130e to be movable relative to the sensor support 120, a user of the lithographic apparatus can vary a distance between the position sensors 130a-130e and therefore allow the simultaneous measurements to be made for different field widths, which provides more flexibility of a user of the lithographic apparatus LA.

In some embodiments, the processor 140 may be configured to combine the measurement signals 132a-132e from at least two different of the plurality of position sensors 130a-130e so as to at least partially correct at least one of the measurement signals 132a-132e for a position error due to one or more eigen modes of the sensor support 120.

In some embodiments of the metrology system 100, the plurality of position sensors 130a-130e may be arranged in a line extending in a first direction (the x-direction in Figures 4 and 5) and each of the plurality of position sensors may be arranged to project its radiation beam in a second direction (the z-direction in Figures 4 and 5) so as to be incident on the substrate W. For such embodiments, the one or more eigen modes of the sensor support 120 may comprise a rotation of the sensor support around an axis of rotation that is generally parallel to the second direction (for example an Rz rotation). The plurality of position sensors 130a-130e may be arranged substantially equally distanced along the first direction. The axis of rotation may, for example, be aligned with a center position sensor 130c of the plurality of position sensors 130a-130e.

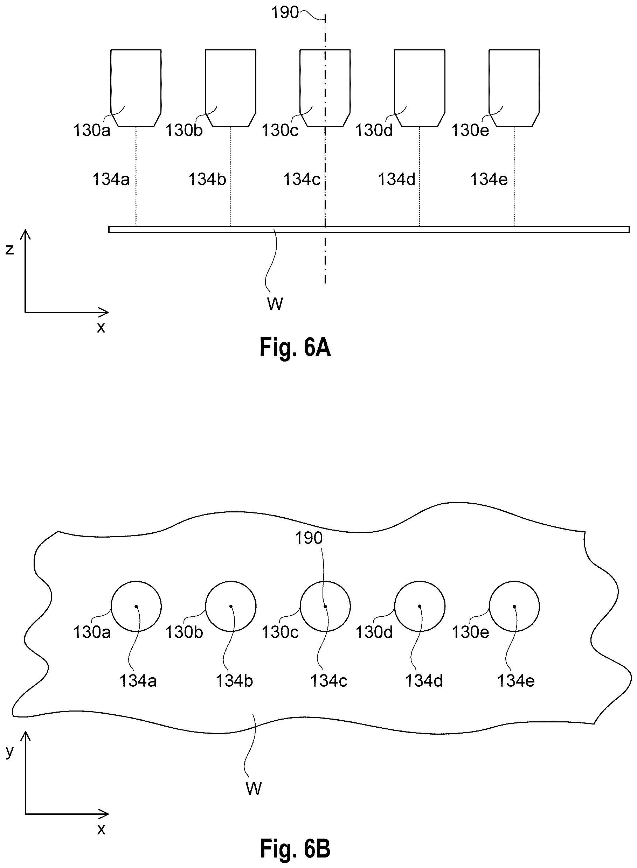

Such an arrangement is shown schematically in Figures 6A to 7. Figure 6A shows a schematic side view of the plurality of position sensors 130a-130e in an x-z plane (a similar view to that shown in Figures 4 and 5); also shown is a section of the substrate W. Figure 6B shows a schematic top view of the plurality of position sensors 130a-130e in an x-y plane; again a section of the substrate W is also shown. In both Figures 6A and 6B a central or chief ray 134a-134e of the radiation projected onto the substrate (generally along the z-direction) is also shown. The one or more eigen modes of the sensor support 120 may comprise a rotation of the sensor support 120 around an axis of rotation 190 that is generally parallel to the z-direction (i.e. an Rz rotation). In the schematic views shown in Figures 5A and 5B, the axis 190 generally coincides with the central or chief ray 134c of the radiation projected onto the substrate W by a central position sensor 130c.

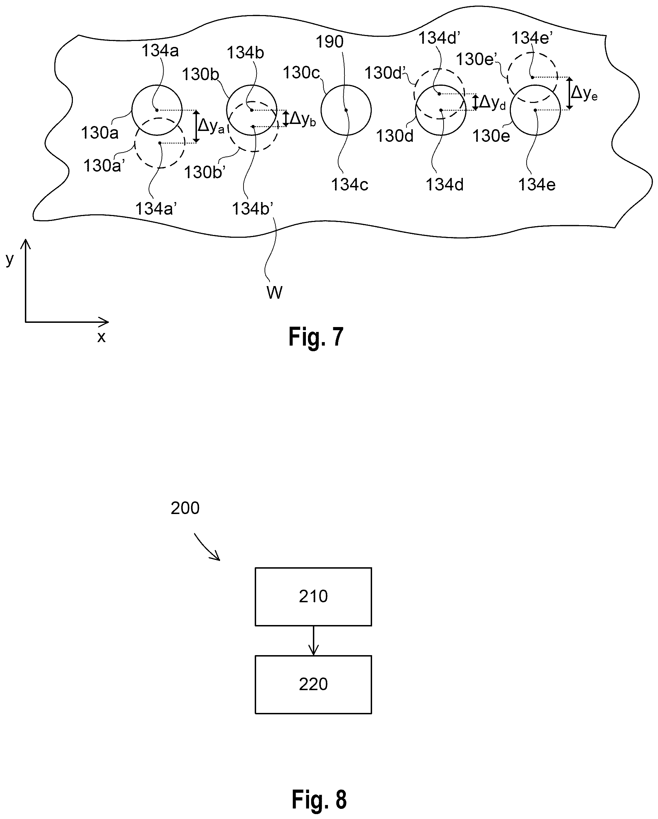

Figure 7 shows an arrangement wherein the plurality of position sensors 130a-130e (and the sensor support 120) have rotated about the axis of rotation 190 from a nominal position (as shown in Figure 6B). Also shown in dashed lines in Figure 7 is a nominal position 130a'-130e' of each of the plurality of position sensors 130a-130e and a nominal position 134a'-134e' of the central or chief ray 134a-134e of the radiation projected onto the substrate W by each of the position sensors 130a-130e. It can be seen from Figure 7 that (with the exception of the central position sensor 130c), this rotation of the entire senor support 120 results in a shift or position error Δ*yₐ*-Δ*yₑ* of the radiation 134a-134e projected onto the substrate W by each of the position sensors 130a-130e relative to the substrate W in a third direction (the y-direction) that is generally perpendicular to the first and second directions. Furthermore, it can be seen from Figure 7 that there is a correlation between the position errors Δ*yₐ*-Δ*yₑ* of the radiation 134a-134e of each of the position sensors 130a-130e in the third direction (the y-direction). In particular, the position errors Δ*yₐ*-Δ*yₑ* of the radiation 134a-134e of each of the position sensors 130a-130e in the third direction (the y-direction) are correlated with a distance of that position sensor 130a-130e from the rotation axis 190 in the first direction (the x-direction).

It will be appreciated that by combining the measurement signals 132a-132e from all of the position sensors 130a-130e it may be possible for such position errors Δ*yₐ*-Δ*yₑ* due to this eigen mode to be corrected for.

In some embodiments of the metrology system 100 the processor 140 may be configured to: perform a fitting process on the measurement signals 132a-132e from at least two different of the plurality of position sensors 130a-130e to determine one or more correlated position errors common to all of the at least two different of the plurality of position sensors 130a-130e. The processor 140 may be further configured to: use the determined one or more correlated position errors to at least partially correct at least one of the measurement signals 132a-132e of the at least two different of the plurality of position sensors 130a-130e. The fitting process may comprise elements of machine learning and/or artificial intelligence. The fitting process may comprise a dimensionality reduction technique such as, for example principal component analysis (PCA) and/or linear discriminant analysis (LDA).

Some embodiments of the present disclosure relate to a new exposure apparatus comprising the metrology system 100 shown in Figures 4 and/or 5 and as described above. The exposure apparatus may comprise a lithographic apparatus LA of the type shown in Figure 1 and as described above. Such an exposure apparatus is advantageous as it can benefit from the parallel measurements and reduced position errors that result from the metrology system 100 shown in Figures 4 and 5.

The new exposure apparatus may comprise a lithographic apparatus LA of the type shown in Figure 1 and as described above. The new exposure apparatus may comprise any of the features of the lithographic apparatus LA shown in Figure 1 and/or described above.

In some embodiments, the new exposure apparatus may comprise: a patterning device support MT operable to support a patterning device MA; an illumination system IL operable to illuminate a patterning device MA supported by the patterning device support MT with exposure radiation B; and imaging optics PS arranged to form an image of the patterning device MA on a substrate W supported by the substrate support WT using the exposure radiation.

In some embodiments, at least one corrected position of a target relative to the substrate support WT as determined by the processor 140 may be used to position the substrate support WT during the formation of the image.

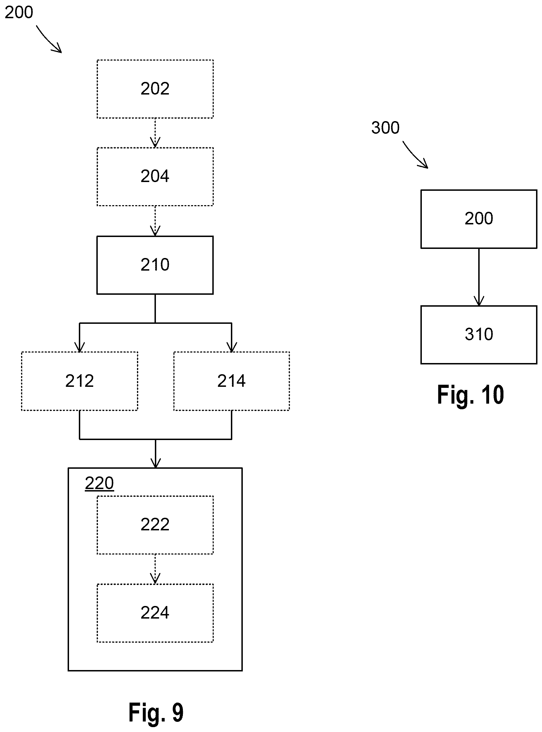

Some embodiments of the present disclosure relate to a new method for determining a correction for a position measurement. An example of such a new method 200 for determining a correction for a position measurement is shown schematically in Figure 8. Figure 9 schematically shows a specific embodiment of the new method 200 shown schematically in Figure 8 with some additional optional features. In general, the optional features of the method 200 are shown in Figure 9 using dotted lines.

The method 200 shown in Figure 8 comprises a step 210 of: using a plurality of position sensors 130a-130e supported by a sensor support 120 to: project a radiation beam onto a substrate W supported by a substrate support 110; receive a portion of the radiation beam scattered from a target on the substrate W; and generate a measurement signal 132a-132e that is indicative of a position of the target relative to that position sensor 130a-130e.

The method 200 shown in Figure 8 further comprises a step 220 of: combining the measurement signals 132a-123e from at least two different of the plurality of position sensors 130a-130e to determine a correction for at least one of the measurement signals 132a-132e for a position error due to a relative movement of the substrate support 110 and the sensor 130a-130e from which the at least one of the measurement signal 132a-132e was received.

The method 200 shown in Figures 8 and 9 may be carried out using the metrology system 100 shown in Figures 4 and/or 5. The method 200 shown in Figures 8 and 4 may comprise any combination of the features of the metrology system 100 shown in Figures 4 and/or 5. The method 200 shown in Figures 8 and 9 is advantageous for the reasons discussed above with reference to the metrology system 100 shown in Figures 4 and/or 5.

In some embodiments, the method 200 may comprise a step 202 of identifying at least one eigen mode of the sensor support 120. The method may further comprise a step 204 of, for the or each at least one identified eigen mode (identified at step 202), determining a correlation between a contribution to the position errors of each of the plurality of position sensors 130a-130e. Note that the step 202 of identifying at least one eigen mode of the sensor support 120 and/or the step 204 of determining a correlation for the or each identified eigen mode may be performed once and may, for example, be stored in memory. This is in contrast to the step 210 generating the measurement signals 132a-132e and the step 220 of combining the measurement signals 132a-123e, which may be performed a plurality of times for each wafer W.

For embodiments comprising steps 202 and/or 204, the step 220 of combining the measurement signals 132a-123e from at least two different of the plurality of position sensors 130a-130e may comprise the following sub-steps. Step 220 may comprise a step 222 of, for each eigen mode (for example identified at step 202), identifying a signal from the measurement signals 132a-132e from at least two different of the plurality of position sensors 130a-130e corresponding to an identified correlation (as identified at step 204) between a contribution to the position errors of each of the plurality of position sensors 130a-130e. Step 220 may further comprise a step 224 of determining the correction for at least one of the measurement signals 132a-132e in dependence on the or each identified signal (as identified at step 222).

In some embodiments of the method 200, the correction may be for at least partially correcting the measurement signal 132a-132e of at least one position sensor 130a-130e for a time-dependent position error due to a relative movement of the substrate support 110 and the sensor 130a-130e from which the at least one of the measurement signal 132a-132e was received.

In some embodiments, the method 200 may further comprise moving the substrate support 110 relative to the sensor support 120 or vice versa while the measurement signals 132a-132e are being generated (at step 210). For example, the substrate support 110 may comprise a wafer stage that is movable relative to the sensor support 120.

In some embodiments of the method 200 each of the plurality of position sensors 130a-130e may comprise a self-referencing interferometer that is operable to receive at least two diffraction beams scattered from the target on the substrate W and to spatially overlap these so that they mutually interfere. The measurement signal 132a-132e may be generated from said interference.

In some embodiments of the method 200 shown in Figure 8, the sensor support 120 may be supported by a main support 160.

The method 200 may further comprise a sensor alignment step 212. The sensor alignment step 212 may comprise: determining a position and/or an orientation of at least one of the plurality of sensors 130a-130e relative to the main support 160. The sensor alignment step 212 may further comprise using the determined position and/or an orientation of at least one of the plurality of sensors 130a-130e relative to the main support 160 to apply a correction to the measurement signal 132a-132e received from a corresponding position sensor 130a-130e before the measurement signals 132a-132e are combined (at step 220) to determine the correction for the at least one of the measurement signals 132a-132e.

Such a correction based on the determined position and/or an orientation of at least one of the plurality of sensors 130a-130e relative to the main support 160 may be determined by a sensor measurement system 170 and may be referred to as an alignment reference axis (ARA) correction.

The method 200 of any one of claims 20 to 24 may further comprise a substrate support alignment step 214. The substrate support alignment step 214 may comprise determining a position and/or an orientation of the substrate support 110 relative to the main support 160. The substrate support alignment step 214 may further comprise using the determined position and/or an orientation of the substrate support 110 relative to the main support 160 to apply a correction to the measurement signals 132a-132e received the plurality of position sensors 130a-130e before the measurement signals 132a-132e are combined (at step 220) to determine the correction for the at least one of the measurement signals 132a-132e.

The substrate support 110 may be referred to as a stage or a wafer stage. Such a correction based on the determined position and/or an orientation of the substrate support 110 relative to the main support 160 may be referred to as a stage position measurement (SPM).

It will be appreciated that the sensor alignment step 212 and the substrate support alignment step 214 may be carried out in any order (or simultaneously).

In some embodiments of the method 200, the correction may be for at least partially correcting at least one of the measurement signals 132a-132e for a position error due to one or more eigen modes of the sensor support 120.

In some embodiments of the method, the step 220 of determining the correction may comprise performing a fitting process on the measurement signals 132a-132e from at least two different position sensors 130a-130e of the plurality of position sensors 130a-130e to determine one or more correlated position errors common to all of the at least two different position sensors 130a-130e of the plurality of position sensors 130a-130e. In some embodiments of the method, the step 220 of determining the correction may further comprise using the determined one or more correlated position errors to determine a correction for the measurement signals 132a-132e of the at least two different position sensors 130a-130e of the plurality of position sensors 130a-130e.

The fitting process may comprise elements of machine learning and/or artificial intelligence. The fitting process may comprise a dimensionality reduction technique such as, for example principal component analysis (PCA) and/or linear discriminant analysis (LDA).

Some embodiments of the present disclosure relate to a new method for determining a position of a plurality of targets on a substrate. An example of such a new method 300 for determining a position of a plurality of targets on a substrate W is shown schematically in Figure 10.

The method 300 for determining a position of a plurality of targets on a substrate W comprises a step 200 of determining the correction for at least one of the measurement signals 132a-132e for a position error due to a relative movement of the substrate support 110 and the sensor 130a-130e from which the at least one of the measurement signal 132a-132e was received using the method 200 shown in Figures 8 and/or 9.

The method 300 for determining a position of a plurality of targets on a substrate W comprises a step 310 of applying the or each correction (determined at step 200) so as to correct the at least one of the measurement signals 130a-130e for said position error.

Although the lithographic apparatus LA shown in Figure 1 is of the form of an extreme ultraviolet (EUV) lithographic apparatus embodiments of the present disclosure may alternatively relate to deep ultraviolet (DUV) lithographic apparatus.

Although the lithographic apparatus LA shown in Figure 1 comprises two substrate tables WT1, WT2 which are each configured to support a substrate W, some other embodiments of the present disclosure may alternatively relate to a lithographic apparatus having a single such substrate table (or more than two such substrate tables).

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference has been made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate such as, for example, a glass substrate or panel) or mask (or other patterning device). These apparatuses may be generally referred to as lithographic tools. Such a lithographic tool may use vacuum conditions or ambient (non-vacuum) conditions. A substrate clamp according to an embodiment of the invention may form part of a lithographic tool.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A metrology system for determining a position of a plurality of targets on a substrate, the metrology system comprising:
a substrate support for supporting a substrate;
a sensor support;
a plurality of position sensors supported by the sensor support, wherein each of the plurality of position sensors is operable to: project a radiation beam onto a substrate supported by the substrate support; receive a portion of the radiation beam scattered from a target on the substrate; and generate a measurement signal that is indicative of a position of the target relative to that position sensor; and
a processor configured to:
receive the measurement signal from each of the plurality of position sensors; and
to combine the measurement signals from at least two different of the plurality of position sensors to at least partially correct at least one of the measurement signals for a position error due to a relative movement of the substrate support and the sensor from which the at least one of the measurement signal was received so as to determine a corrected position of the target relative to the substrate support.

2. The metrology system of claim 1 wherein the processor is configured, for at least one of the plurality of position sensors, to use the measurement signals from at least one different one of the plurality of position sensors to at least partially correct the measurement signal of that position sensor for a position error due to a relative movement of the substrate support and the sensor from which the at least one of the measurement signal was received so as to determine a corrected position of the target relative to the substrate support.

3. The metrology system of any preceding claim wherein the processor is configured to at least partially correct the measurement signal of at least one position sensor for a time-dependent position error due to a relative movement of the substrate support and the sensor from which the at least one of the measurement signal was received.

4. The metrology system of any preceding claim further comprising a movement mechanism operable to cause relative movement of the substrate support and the sensor support.

5. The metrology system of any preceding claim wherein each of the plurality of position sensors comprises a self-referencing interferometer that is operable to receive at least two diffraction beams scattered from the target on the substrate and to spatially overlap these so that they mutually interfere and wherein the measurement signal is generated from said interference.

6. The metrology system of any preceding claim further comprising a main support and wherein the sensor support is supported by the main support.

7. The metrology system of claim 6 wherein the sensor support is rigidly connected to the main support.

8. The metrology system of claim 6 or claim 7 further comprising at least one sensor measurement system operable to determine a position and/or an orientation of at least one of the plurality of sensors relative to the main support.

9. The metrology system of claim 8 wherein the processor is operable to:
receive at least one sensor signal that is indicative of position and/or an orientation of one of the plurality of sensors relative to the main support; and
use the or each sensor signal to apply a correction to the measurement signal received from a corresponding position sensor before the measurement signals are combined to at least partially correct the measurement signal of the at least one of the plurality of position sensors for a position error due to a relative movement of the substrate support and the position sensor(s).

10. The metrology system of any one of claims 6 to 9 wherein the substrate support is movable relative to the main support.

11. The metrology system of claim any one of claims 6 to 10 further comprising at least one substrate support measurement system operable to determine a position and/or an orientation of the substrate support relative to the main support.

12. The metrology system of claim 11 wherein the processor is operable to:
receive a substrate support signal that is indicative of position and/or an orientation of the substrate support relative to the main support; and
use the sensor support signal to apply a correction to the measurement signals received from the plurality of position sensors before they are combined to at least partially correct the measurement signal of the at least one of the plurality of position sensors for a position error due to a relative movement of the substrate support and the position sensor(s).

13. The metrology system of any preceding claim wherein at least one of the plurality of position sensors is movable relative to the sensor support.

14. The metrology system of any preceding claim wherein the processor is configured to combine the measurement signals from at least two different of the plurality of position sensors so as to at least partially correct at least one of the measurement signals for a position error due to one or more eigen modes of the sensor support.

15. The metrology system of claim 14 wherein the plurality of position sensors are arranged in a line extending in a first direction, each of the plurality of position sensors are arranged to project its radiation beam in a second direction so as to be incident on the substrate and wherein the one or more eigen modes of the sensor support comprises a rotation of the sensor support around an axis of rotation that is generally parallel to the second direction.

16. The metrology system of any preceding claim wherein the processor is configured to:
perform a fitting process on the measurement signals from at least two different of the plurality of position sensors to determine one or more correlated position errors common to all of the at least two different of the plurality of position sensors; and
to use the determined one or more correlated position errors to at least partially correct the measurement signals of at least one of the at least two different of the plurality of position sensors.

17. An exposure apparatus comprising the metrology system of any preceding claim.

18. The exposure apparatus of claim 17 comprising:
a patterning device support operable to support a patterning device;
an illumination system operable to illuminate a patterning device supported by the patterning device support with exposure radiation; and
imaging optics arranged to form an image of the patterning device on a substrate supported by the substrate support using the exposure radiation.

19. The exposure apparatus of claim 17 of claim 18 wherein at least one corrected position of a target relative to the substrate support as determined by the processor is used to position the substrate support during the formation of the image.

20. A method for determining a correction for a position measurement, the method comprising:
using a plurality of position sensors supported by a sensor support to: project a radiation beam onto a substrate supported by a substrate support; receive a portion of the radiation beam scattered from a target on the substrate; and generate a measurement signal that is indicative of a position of the target relative to that position sensor; and
combining the measurement signals from at least two different of the plurality of position sensors to determine a correction for at least one of the measurement signals for a position error due to a relative movement of the substrate support and the sensor from which the at least one of the measurement signal was received.

21. The method of claim 20 comprising:
identifying at least one eigen mode of the sensor support;
for the or each at least one identified eigen mode, determine a correlation between a contribution to the position errors of each of the plurality of position sensors;
for each eigen mode identifying a signal from the measurement signals from at least two different of the plurality of position sensors corresponding to the identified correlation between a contribution to the position errors of each of the plurality of position sensors; and
determining the correction for at least one of the measurement signals in dependence on the or each identified signal.

22. The method of claim 20 or claim 21 wherein the correction is for at least partially correcting the measurement signal of at least one position sensor for a time-dependent position error due to a relative movement of the substrate support and the sensor from which the at least one of the measurement signal was received.

23. The method of any one of claims 20 to 22 further comprising moving the substrate support relative to the sensor support or vice versa while the measurement signals are being generated.

24. The method of any one of claims 20 to 23 wherein each of the plurality of position sensors comprises a self-referencing interferometer that is operable to receive at least two diffraction beams scattered from the target on the substrate and to spatially overlap these so that they mutually interfere and wherein the measurement signal is generated from said interference.

25. The method of any one of claims 20 to 24 wherein the sensor support is supported by a main support and wherein the method further comprises:
determining a position and/or an orientation of at least one of the plurality of sensors relative to the main support; and
using the determined position and/or an orientation of at least one of the plurality of sensors relative to the main support to apply a correction to the measurement signal received from a corresponding position sensor before the measurement signals are combined to determine the correction for the at least one of the measurement signals.

26. The method of any one of claims 20 to 24 wherein the method further comprises:
determining a position and/or an orientation of the substrate support relative to the main support; and
using the determined position and/or an orientation of the substrate support relative to the main support to apply a correction to the measurement signals received the plurality of position sensors before the measurement signals are combined to determine the correction for the at least one of the measurement signals.

27. The method of any one of claims 20 to 26 wherein the correction is for at least partially correcting at least one of the measurement signals for a position error due to one or more eigen modes of the sensor support.

28. The method of any one of claims 20 to 27 wherein determining the correction comprises:
performing a fitting process on the measurement signals from at least two different position sensors of the plurality of position sensors to determine one or more correlated position errors common to all of the at least two different position sensors of the plurality of position sensors; and
using the determined one or more correlated position errors to determine a correction for the measurement signals of at least one of the at least two different position sensors of the plurality of position sensors.

29. A method for determining a position of a plurality of targets on a substrate, the method comprising:
determining the correction for at least one of the measurement signals for a position error due to a relative movement of the substrate support and the sensor from which the at least one of the measurement signal was received using the method of any one of claims 20 to 28; and
applying the or each correction so as to correct the at least one of the measurement signals for said position error.
